# EUROPÄISCHE PATENTANMELDUNG

(11) **EP 2 818 686 A1**
(43) Veröffentlichungstag der Anmeldung: **31.12.2014**
(21) Anmeldenummer: 14172286.8
(22) Anmeldetag: 13.06.2014
(51) Int. Cl.: F02M 51/06, H01L 41/083, H01L 41/053

(54) **Piezoaktor und Verfahren zum Herstellen eines Piezoaktors**

(30) Priorität: 26.06.2013 DE 102013212279
(71) Anmelder: ROBERT BOSCH GMBH, 70442 Stuttgart (DE)
(72) Erfinder: Cromme, Peter, 96050 Bamberg (DE)

(57) **Zusammenfassung**

Die Erfindung betrifft einen Piezoaktor (20) für eine von einem Medium umströmte Anordnung (10), mit mehreren Piezoelementen (16) und einem die mehreren Piezoelemente (16) umgebenden Schutzsystem (35), wobei das Schutzsystem (35) wenigstens eine Schicht (40) umfasst, die schädliche Bestandteile absorbierende Eigenschaften aufweist. Erfindungsgemäß ist es vorgesehen, dass die wenigstens Schicht (40) an der den mehreren Piezoelementen (16) zugewandten Seite eines die mehreren Piezoelementen (16) umgebenden Schutzelements angeordnet ist.

## Beschreibung

### Stand der Technik

Die Erfindung betrifft einen Piezoaktor für eine von einem Medium umströmte Anordnung nach dem Oberbegriff des Anspruchs 1. Ferner betrifft die Erfindung ein Verfahren zum Herstellen eines erfindungsgemäßen Piezoaktors.

Ein derartiger Piezoaktor ist aus der DE 10 2007 040 508 A1 der Anmelderin bekannt. Er dient als Bestandteil eines Kraftstoffeinspritzventils zum Einspritzen von Kraftstoff in den Brennraum einer Brennkraftmaschine. Der Piezoaktor ist innerhalb des Gehäuses des Kraftstoffinjektors angeordnet und von Kraftstoff umströmt. Um zu verhindern, dass für die Piezoelemente schädliche Bestandteile des Kraftstoffs in Wirkverbindung mit den Piezoelementen gelangen und diese, insbesondere über die Betriebsdauer des Kraftstoffinjektors betrachtet, beschädigen bzw. deren Funktion beeinträchtigen, ist der bekannte Piezoaktor von einem Schutzsystem umgeben, das wenigstens eine Schicht umfasst, die für die schädlichen Bestandteile (des Kraftstoffs) absorbierende Eigenschaften aufweist. Dadurch werden diese Bestandteile von dem Material der wenigstens einen Schutzschicht aufgenommen und gebunden, ohne dass sie in Wirkverbindung mit den Piezoelementen gelangen können. In konkreter Ausgestaltung ist es bei der bekannten Schrift vorgesehen, dass die Piezoelemente mit einer funktionellen Schicht aus einem organischen, medienbeständigen Gel oder Elastomer umgeben sind, das eine Beimengung eines die schädlichen Bestandteile absorbierenden Mittels enthält, insbesondere ein Zeolith. Der so ausgebildete zylindrische Piezoaktor, bestehend aus den gestapelten Piezoelementen und dem die Piezoelemente schlauchförmig umgebenden Schutzsystem, ist mit radialem Abstand zu einer Gehäuseinnenwand des Kraftstoffinjektors in diesem angeordnet.

Aus dem Stand der Technik ist es darüber hinaus bekannt, Piezoelemente in einer elastische Eigenschaften aufweisenden Vergussmasse anzuordnen und diese Vergussmasse wiederum innerhalb einer starren Schutzhülse, bestehend aus Metall oder Kunststoff, zu positionieren. Beim Umgießen der Piezoelemente mit der angesprochenen Vergussmasse erfolgt dies insbesondere in Produktionsstätten, die bezüglich der Luftfeuchtigkeit, je nach Witterungsbedingungen, eine Luftfeuchtigkeit von mehr als 5 % relativer Luftfeuchtigkeit aufweisen können. Derartige Luftfeuchtigkeiten können zu einem Feuchtigkeitseintrag in die Vergußmasse führen mit der Gefahr, dass die in der Vergußmasse eingelagerten Feuchtigkeitsmoleküle nach und nach in Richtung der Piezoelemente diffundieren und dort zu Funktionsbeeinträchtigungen führen. Man könnte nun zwar versuchen, durch entsprechende Klimatisierungseinrichtungen dafür Sorge zu tragen, dass beim Vergießen die Umgebungsbedingungen trocken sind, beispielsweise durch eine entsprechende Klimaanlage, dies erfordert jedoch einen zusätzlichen Investitionsaufwand und muss darüber hinaus aus Gründen der Prozessüberwachung ständig kontrolliert bzw. überwacht werden.

### Offenbarung der Erfindung

Ausgehend von dem dargestellten Stand der Technik liegt der Erfindung die Aufgabe zugrunde, einen Piezoaktor für eine in einem Medium umströmte Anordnung nach dem Oberbegriff des Anspruchs 1 derart weiterzubilden, dass insbesondere die Gefahr von Funktionsbeeinträchtigungen des Piezoaktors, verursacht durch dessen Fertigung bei relativ hoher Luftfeuchtigkeit (gemeint ist hierbei insbesondere eine relative Luftfeuchtigkeit von mehr als 5%) reduziert bzw. ausgeschlossen wird. Darüber hinaus soll auch während des Betriebs des Piezoaktors eine Funktionsbeeinträchtigung durch das den Piezoaktor umströmende Medium (insbesondere Kraftstoff), ausgeschlossen werden. Dies soll bei einem relativ kompakten Aufbau des Piezoaktors, d.h. insbesondere bei einem relativ geringen Durchmesser ermöglicht werden.

Diese Aufgabe wird erfindungsgemäß bei einem Piezoaktor für eine von einem Medium umströmte Anordnung mit den Merkmalen des Anspruchs 1 dadurch gelöst, dass die wenigstens eine Schicht des Schutzsystems an der den mehreren Piezoelementen zugewandten Seite eines die mehreren Piezoelemente umgebenden Schutzelements angeordnet ist. Das Schutzsystem besteht somit aus (wenigstens) zwei Schutzelementen, einerseits dem die Piezoelemente radial umgebenden Schutzelement (insbesondere in Form einer aus Metall oder Kunststoff bestehenden Schutzhülse), das während des Betriebs des Piezoaktors ein Eindringen von Kraftstoff in den Piezoaktor verhindert, und zum zweiten aus wenigstens einer Schicht, die an der Innenseite des Schutzelements angeordnet ist und schädliche Bestandteile absorbierende Eigenschaften (insbesondere für den während der Fertigung vorhandenen Wasserdampf bzw. Feuchtigkeit) aufweist, so dass der während der Fertigung stattfindende Feuchtigkeitseintrag beim Vergießen durch die wenigstens eine Schicht aufgenommen werden kann.

Vorteilhafte Weiterbildungen des erfindungsgemäßen Piezoaktors sind in den Unteransprüchen aufgeführt.

In konstruktiv bevorzugter Ausgestaltung des Schutzelements ist dieses als eine vorzugsweise aus Metall oder Kunststoff bestehende starre Schutzhülse ausgebildet. Durch die starre Ausbildung der Schutzhülse wird insbesondere eine hinreichend hohe mechanische Festigkeit bzw. Robustheit erzielt. Gleichzeitig ermöglicht es die hülsenförmige Form des Schutzelements, dass die Piezoelemente bzw. die die Piezoelemente umgebende Vergussmasse zusammen mit dem Schutzelement im Durchmesser relativ kompakt baut.

Zur Erzielung einer wasser- bzw. wasserdampfabsorbierenden Schutzschicht wird vorgeschlagen, dass die wenigstens eine (Schutz-) Schicht zumindest Bestandteile auf Grundlage von Zeolith aufweist.

Insbesondere ist es vorgesehen, dass das Zeolith vom Typ Y mit der chemischen Formel Na₅₆ [(AlO₂)₅₆(SiO₂)₁₃₆] • 250H₂O ist.

Um eine genügend hohe Speicherkapazität auch bei einer relativ hohen Luftfeuchtigkeit während des Produktionsprozesses des Piezoaktors zu ermöglichen, ist es bevorzugt vorgesehen, dass die Dicke der wenigstens einen Schicht zwischen 250µm und 1000µm beträgt. Dabei kann die Schicht beispielsweise in mehreren, aufeinanderfolgenden Schritten aufgebracht werden, oder aber in einem einzigen Schritt.

In fertigungstechnisch bevorzugter Ausgestaltung ist es vorgesehen, dass das Zeolith Bestandteil einer Paste ist. Eine derartige Paste ermöglicht beispielsweise eine Mindestauftragsdicke von 20µm bis hin zu den angesprochenen 250µm bzw. 1000µm und kann durch Aufdrucken oder auf sonstige Art und Weise mit der Innenseite des Schutzelements (Schutzhülse) in Wirkverbindung gebracht werden.

Ein konstruktiv bevorzugter Aufbau des Piezoaktors sieht darüber hinaus vor, dass die mehreren Piezoelemente in einer elastische Eigenschaften aufweisenden Vergussmasse angeordnet sind, auf deren der mehreren Piezoelemente abgewandten Seite die wenigstens eine Schicht angrenzt.

Die Erfindung umfasst auch ein Verfahren zum Herstellen eines erfindungsgemäßen Piezoaktors. Dabei ist es vorgesehen, dass die wenigstens eine schädliche Bestandteile absorbierende Schicht auf eine Innenseite eines Metall oder Kunststoff bestehenden Schutzelements aufgebracht wird.

Eine bevorzugter Fertigungsablauf für den Piezoaktor sieht darüber hinaus vor, dass die mehreren Piezoelemente in das mit der wenigstens einen Schicht versehene Schutzelement eingebracht werden, und dass anschließend der Zwischenraum zwischen den mehreren Piezoelementen und der wenigstens einen Schicht mit einer elastische Eigenschaften aufweisenden Vergussmasse ausgegossen wird.

Ein bevorzugter Einsatz des Piezoaktors besteht als Bestandteil eines Kraftstoffinjektors zum Einspritzen von Kraftstoff in den Brennraum einer Brennkraftmaschine ist.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: einen Längsschnitt durch einen Kraftstoffinjektor mit einem erfindungsgemäßen Piezoaktor und
- Fig. 2: einen Schnitt in der Ebene II-II der Fig. 1.

Gleiche Elemente bzw. Elemente mit gleicher Funktion sind in den Figuren mit den gleichen Bezugsziffern versehen.

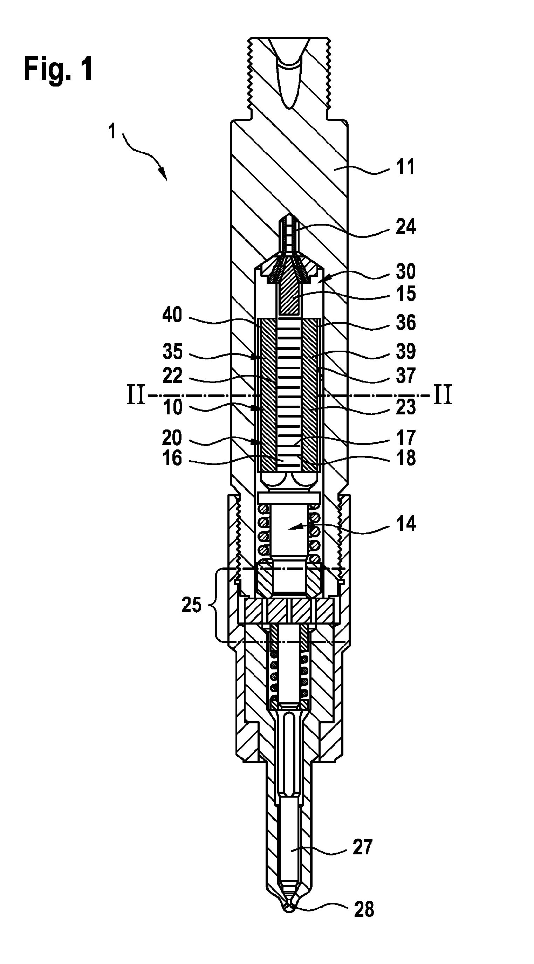

In der Fig. 1 ist ein Kraftstoffinjektor 1 zum Einspritzen von Kraftstoff in einen nicht dargestellten Brennraum einer Brennkraftmaschine dargestellt. Der Kraftstoffinjektor 1 ist als sogenannter Piezoinjektor ausgebildet und umfasst einen Haltekörper 11 als Teil des Injektorgehäuses und ein in dem Haltekörper 11 angeordnetes Piezoaktormodul 10. Das Piezoaktormodul 10 umfasst u.a. einen Aktorkopf 14 und einen Aktorfuß 15. Zwischen dem Aktorkopf 14 und dem Aktorfuß 15 sind eine Vielzahl von übereinandergestapelten Piezoelementen 16 zur Bildung des eigentlichen, erfindungsgemäßen Piezoaktors 20 vorhanden, die jeweils aus Piezolagen aus Piezokeramik und diese einschließende Innenelektroden 17 und 18 bestehen. Die Innenelektroden 17 und 18 der Piezoelemente 16 sind mit Außenelektroden 22 und 23 und diese wiederum über ein Steckerteil 24 elektrisch kontaktiert.

Das Piezoaktormodul 10 ist über einen Koppler 25 mit einer Düsennadel 27 verbunden. Durch Anlegen einer Spannung an die Piezoelemente 16 über die Innenelektroden 17 und 18 und die daraus folgende mechanische Reaktion wird eine Düsenöffnung 28 freigegeben, über die der Kraftstoff in den Brennraum der Brennkraftmaschine abgegeben wird. Das Piezoaktormodul 10 wird bei der dargestellten Anordnung gemäß Fig. 1 als Kraftstoffinjektor 1 in einem Raum 30 von dem in den Brennraum einzudosierenden Kraftstoff umströmt.

Um einerseits den Piezoaktor 20 vor den schädlichen Einflüssen des den Piezoaktor 20 umströmenden Kraftstoffs zu schützen, und andererseits zu verhindern, dass bereits während der Fertigung des Piezoaktors 20 aus der Atmosphäre insbesondere Feuchtigkeit in den Bereich des Piezoaktors 20 gelangt, die über die Betriebsdauer des Kraftstoffinjektor 1 betrachtet zu einer Beeinträchtigung der Funktionsfähigkeit führen kann, weist der Kraftstoffinjektor 1 bzw. der Piezoaktor 20 ein Schutzsystem 35 auf.

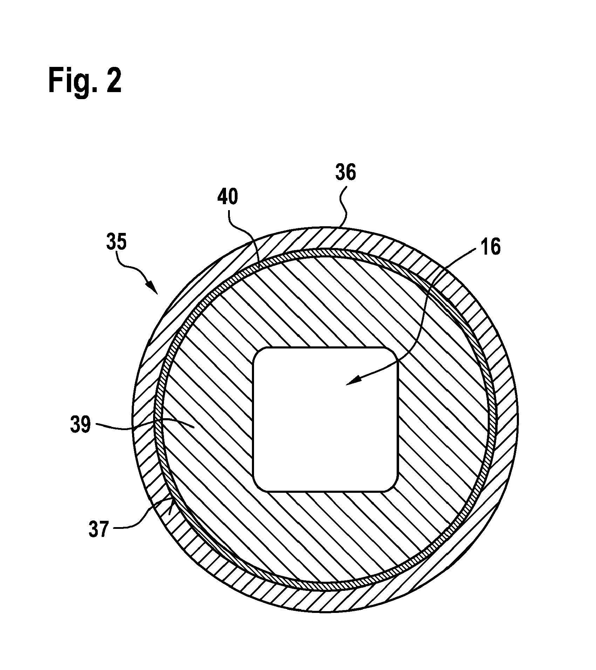

Das Schutzsystem 35 umfasst ein die Piezoelemente 16 mit radialem Abstand umgebendes Schutzelement in Form einer aus Metall oder Kunststoff bestehenden Schutzhülse 36. Hierzu ist es vorgesehen, dass die Piezoelemente 16, die entsprechend der Darstellung der Fig. 2 beispielhaft einen in etwa quadratischen Querschnitt aufweisen, in der Längsachse der Schutzhülse 36 mit radialem Abstand zur Innenwand 37 der Schutzhülse 36 angeordnet sind. Der radiale Zwischenraum zwischen den Piezoelementen 16 und der Innenwand 37 der Schutzhülse 36 ist von einer elastische Eigenschaften aufweisenden Vergussmasse 39, insbesondere aus Kunststoff bestehend, ausgefüllt. Durch die elastischen Eigenschaften der Vergussmasse 39 wird die Beweglichkeit der Piezoelemente 16 in Längsrichtung des Piezoaktors 20 ermöglicht.

Erfindungsgemäß ist es vorgesehen, dass an der Innenwand 37 der Schutzhülse 36 wenigstens eine Schicht 40 angeordnet ist, die dazu ausgebildet ist, während der Fertigung des Piezoaktors 20 bzw. beim Ausgießen des radialen Innenraums zwischen den Piezoelementen 16 und der Schutzhülse 36 in der Vergussmasse 39 vorhandene schädliche Bestandteile, insbesondere in Form von Wasser, zu absorbieren. Hierzu weist die Schicht 40 eine Schichtdicke von vorzugsweise zwischen 250µm und 1000µm auf, wobei die Schicht 40 entweder durch einen einmaligen Materialauftrag, oder aber durch mehrmaliges Auftragen an der Innenwand 37 der Schutzhülse 36 ausgebildet wird. Das Aufbringen der Schicht 40 erfolgt dadurch, dass die Bestandteile der Schicht 40 sich in einer Paste befinden, die ggf. ein Trägermaterial für die erfindungswesentlichen Elemente der Schicht 40 aufweist. Die Paste wird mittels üblicher bekannter Auftragsverfahren (zum Beispiel Aufrakeln, Aufsprühen o.ä.) auf die Innenseite 37 der Schutzhülse 36 aufgebracht.

Die Paste bzw. die Schicht 40 enthält zumindest Bestandteile auf Grundlage von Zeolith. Insbesondere ist es vorgesehen, dass das Zeolith vom Typ Y mit der chemischen Formel Na₅₆ [(AlO₂)₅₆(SiO₂)₁₃₆]• 250H₂O ist. Ein derartiges Zeolith vom Typ Y kann beispielsweise 250 Wassermoleküle durch Adsorption immobilisieren. Durch verschiedene chemische Modifikationen der Zeolithe ist es möglich, Zeolithe mit unterschiedlichen Adsorptionseigenschaften herzustellen. Diesbezüglich wird auf die Offenbarung der DE 10 2007 040 508 A1 der Anmelderin verwiesen, die insofern Bestandteil der vorliegenden Anmeldung sein soll.

Die Fertigung des aus den Piezoelementen 16, der Vergussmasse 39, der wenigstens einen Schicht 40 und der Schutzhülse 36 bestehenden Piezoaktors 20 erfolgt vorzugsweise dadurch, dass in einem separaten Bearbeitungsschritt die wenigstens eine Schicht 40 auf die Innenwand 37 der Schutzhülse 36 aufgebracht wird. Anschließend werden die Piezoelemente 16 innerhalb der Schutzhülse 36 positioniert und der radiale Innenraum zwischen den Piezoelementen 16 und der Schicht 40 von der Vergussmasse 39 ausgefüllt, die anschließend elastisch aushärtet.

Der soweit beschriebene Piezoaktor 20 kann in vielfältiger Art und Weise abgewandelt bzw. modifiziert werden, ohne vom Erfindungsgedanken abzuweichen. Insbesondere kann es vorgesehen sein, dass die Schutzhülse 36 wiederum im Bereich des Aktorkopfes 14 bzw. des Aktorfußes 15 mit einem bzw. mehreren Schutzelementen versehen ist, um während des Betriebs des Kraftstoffinjektors 1 ein Eindringen von Kraftstoff von der Stirnseite der Schutzhülse 36 in die Vergussmasse 39 zu vermeiden. Derartige Schutzmaßnahmen sind aus dem Stand der Technik an sich bekannt und sind daher in der vorliegenden Anmeldung, da nicht erfindungswesentlich, nicht dargestellt. Darüber hinaus ist es möglich, dass die Schicht 40 aus einem anderen Material besteht als Zeolith. Wesentlich ist lediglich, dass die Schicht 40 dazu ausgebildet ist, insbesondere bei der Fertigung des Piezoaktors 20 über die Vergussmasse 39 aufgenommene schädliche Bestandteile zu absorbieren.

## Patentansprüche

1. Piezoaktor (20) für eine von einem Medium umströmte Anordnung (10), mit mehreren Piezoelementen (16) und einem die mehreren Piezoelemente (16) umgebenden Schutzsystem (35), wobei das Schutzsystem (35) wenigstens eine Schicht (40) umfasst, die für die Piezoelemente (16) schädliche Bestandteile absorbierende Eigenschaften aufweist,
**dadurch gekennzeichnet,**
**dass** die wenigstens eine Schicht (40) an der den mehreren Piezoelementen (16) zugewandten Seite eines die mehreren Piezoelementen (16) umgebenden Schutzelements angeordnet ist.

2. Piezoaktor nach Anspruch 1,
**dadurch gekennzeichnet,**
**dass** das Schutzelement als eine vorzugsweise aus Metall oder Kunststoff bestehende starre Schutzhülse (36) ausgebildet ist.

3. Piezoaktor nach Anspruch 1 oder 2,
**dadurch gekennzeichnet,**
**dass** die wenigstens eine Schicht (40) zumindest Bestandteile auf Grundlage von Zeolith aufweist.

4. Piezoaktor nach Anspruch 3,
**dadurch gekennzeichnet,**
**dass** das Zeolith vom Typ Y mit der chemischen Formel Na₅₆ [(AlO₂)₅₆(SiO₂)₁₃₆]• 250H₂O ist.

5. Piezoaktor nach einem der Ansprüche 1 bis 4,
**dadurch gekennzeichnet,**
**dass** die Dicke der wenigstens einen Schicht (40) zwischen 250µm und 1000µm beträgt.

6. Piezoaktor nach einem der Ansprüche 3 bis 5,
**dadurch gekennzeichnet,**
**dass** das Zeolith Bestandteil einer Paste ist.

7. Piezoaktor nach einem der Ansprüche 2 bis 6,
**dadurch gekennzeichnet,**
**dass** die mehreren Piezoelemente (16) in einer Vergußmasse (39) angeordnet sind, auf deren der mehreren Piezoelemente (16) abgewandten Seite die wenigstens eine Schicht (40) angrenzt.

8. Verfahren zum Herstellen eines Piezoaktors nach einem der Ansprüche 1 bis 7,
**dadurch gekennzeichnet,**
**dass** die wenigstens eine schädliche Bestandteile absorbierende Schicht (40) auf eine Innenseite eines aus Metall oder Kunststoff bestehenden Schutzelements, aufgebracht wird, wobei als Schutzelement insbesondere eine starre, aus Kunststoff oder Metall bestehende Schutzhülse (36) verwendet wird.

9. Verfahren nach Anspruch 8,
**dadurch gekennzeichnet,**
**dass** die mehreren Piezoelemente (16) in das mit der wenigstens einen Schicht (40) versehene Schutzelement eingebracht werden, und dass anschließend der Zwischenraum zwischen den mehreren Piezoelementen (16) und der wenigstens einen Schicht (40) mit einer elastische Eigenschaften aufweisenden Vergußmasse (39) ausgegossen wird.

10. Piezoaktor nach einem der Ansprüche 1 bis 7,
**dadurch gekennzeichnet,**
**dass** der Piezoaktor (20) Bestandteil eines Kraftstoffinjektors (1) ist.
